# EUROPEAN PATENT APPLICATION

(11) **EP 4 718 968 A1**
(43) Date of publication of application: **01.04.2026**
(21) Application number: 25169859.3
(22) Date of filing: 10.04.2025
(51) Int. Cl.: H10B 12/00

(54) **THREE-DIMENSIONAL SEMICONDUCTOR DEVICE AND METHOD OF FABRICATING THE SAME**

(30) Priority: 27.09.2024 KR 20240131882
(71) Applicant: Samsung Electronics Co., Ltd., Suwon-si, Gyeonggi-do 16677 (KR)
(72) Inventor: OH, Gyuhwan, 16677 Suwon-si (KR); HAN, Jinwoo, 16677 Suwon-si (KR)
(74) Representative: Marks & Clerk LLP

(57) **Abstract**

A three-dimensional semiconductor device may include: a substrate; semiconductor patterns that are on the substrate, spaced apart from the substrate, the semiconductor patterns spaced apart from each other in a first direction parallel to a top surface of the substrate; a first gate pattern on top surfaces of the semiconductor patterns and extending in the first direction; a second gate pattern on bottom surfaces of the semiconductor patterns, extending in the first direction, and spaced apart from the first gate pattern; and a bridge pattern between the semiconductor patterns, wherein each of the first gate pattern and the second gate pattern includes: a gate region that is overlapped with the semiconductor patterns; and an extension region that is overlapped with the bridge pattern, and wherein the extension region of the first gate pattern protrudes to a region below the gate region of the first gate pattern.

## Description

### BACKGROUND

### 1. Field

The disclosure relates to a three-dimensional semiconductor device and a method of fabricating the same, and in particular, to a three-dimensional semiconductor device with improved productivity and electric characteristics.

### 2. Description of Background Art

Due to their small-sized, multifunctional, and/or low-cost characteristics, semiconductor devices are being esteemed as important elements in the electronics industry. The semiconductor devices are classified into a semiconductor memory device for storing data, a semiconductor logic device for processing data, and a hybrid semiconductor device including both memory and logic elements.

With the recent trend of high speed and low power consumption of electronic devices, semiconductor devices in the electronic devices are also required to have high operating speeds and/or low operating voltages, and in order to satisfy this requirement, it is important to increase an integration density of the semiconductor device. However, as the integration density of the semiconductor device increases, the semiconductor device may suffer from deteriorated electrical characteristics and low production yield. Accordingly, many studies are being conducted to improve the electrical characteristics and production yield of the semiconductor device.

### SUMMARY

According to an aspect of the disclosure, a three-dimensional semiconductor device with improved productivity and electric characteristics and a method of fabricating the same are provided.

According to an aspect of the disclosure, a three-dimensional semiconductor device may be provided and include: a substrate; semiconductor patterns that are on the substrate, spaced apart from the substrate, the semiconductor patterns spaced apart from each other in a first direction parallel to a top surface of the substrate; a first gate pattern on top surfaces of the semiconductor patterns and extending in the first direction; a second gate pattern on bottom surfaces of the semiconductor patterns, extending in the first direction, and spaced apart from the first gate pattern; and a bridge pattern between the semiconductor patterns, wherein each of the first gate pattern and the second gate pattern includes: a gate region that is overlapped with the semiconductor patterns; and an extension region that is overlapped with the bridge pattern, and wherein the extension region of the first gate pattern protrudes to a region below the gate region of the first gate pattern.

According to an aspect of the disclosure, a three-dimensional semiconductor device may be provided and include: a substrate; semiconductor patterns that are on the substrate, spaced apart from the substrate, the semiconductor patterns spaced apart from each other in a first direction parallel to a top surface of the substrate; a first gate pattern on top surfaces of the semiconductor patterns and extending in the first direction; a second gate pattern on bottom surfaces of the semiconductor patterns, extending in the first direction, and spaced apart from the first gate pattern; and a bridge pattern between the semiconductor patterns, wherein each of the first gate pattern and the second gate pattern includes: a gate region overlapped with the semiconductor patterns; and an extension region overlapped with the bridge pattern, and wherein a distance between the extension region of the first gate pattern and the extension region of the second gate pattern is smaller than a distance between the gate region of the first gate pattern and the gate region of the second gate pattern.

According to an aspect of the disclosure, a three-dimensional semiconductor device may be provided and include: a substrate; first semiconductor patterns on the substrate, spaced apart from the substrate, the first semiconductor patterns spaced apart from each other in a first direction parallel to a top surface of the substrate, and the first semiconductor patterns extending in a second direction that is parallel to the top surface of the substrate and crosses the first direction; second semiconductor patterns spaced apart from the first semiconductor patterns in a third direction perpendicular to the top surface of the substrate; a first gate pattern on top surfaces of the first semiconductor patterns and extending in the first direction; a second gate pattern on bottom surfaces of the first semiconductor patterns, extending in the first direction, and spaced apart from the first gate pattern; a bridge pattern between the first semiconductor patterns; a bit line on a first end of one of the first semiconductor patterns and extending in the third direction; and a data storage pattern on a second end of the one of the first semiconductor patterns, opposite of the first end, and extending in the third direction, wherein each of the first gate pattern and the second gate pattern includes: a gate region overlapped with the first semiconductor patterns; and an extension region overlapped with the bridge pattern, and wherein the extension region of the first gate pattern protrudes to a region lower than the gate region of the first gate pattern.

According to an aspect of the disclosure, a method of fabricating a three-dimensional semiconductor device may be provided and include: forming semiconductor patterns on a substrate, spaced apart from the substrate, wherein the semiconductor patterns are spaced apart from each other in a first direction parallel to a top surface of the substrate; forming a bridge layer that encloses each of the semiconductor patterns and extends in the first direction; performing a removal process on a portion of the bridge layer; forming a sacrificial layer on the semiconductor patterns, the sacrificial layer extending in the first direction; forming an interlayer insulating layer on the sacrificial layer; removing a portion of the sacrificial layer from a region between the interlayer insulating layer and the semiconductor patterns; and forming a gate pattern in an empty region, the empty region formed by the removing the portion of the sacrificial layer, wherein the removal process on the portion of the bridge layer reduces a thickness of the bridge layer.

At least some of the above and other features of the invention are set out in the claims.

### BRIEF DESCRIPTION OF DRAWINGS

FIG. 1 is a circuit diagram schematically illustrating a three-dimensional semiconductor device according to an embodiment of the disclosure.
FIGS. 2A, 2B, and 2C are perspective views schematically illustrating a three-dimensional semiconductor device according to an embodiment of the disclosure.
FIG. 3 is a plan view illustrating a three-dimensional semiconductor device according to an embodiment of the disclosure.
FIG. 4A is a sectional view corresponding to a line A-A' of FIG. 3.
FIG. 4B is a sectional view corresponding to a line B-B' of FIG. 3.
FIGS. 5A, 5B, 5C, and 5D are enlarged views illustrating a portion P1 of FIG. 4A.
FIG. 6 is a sectional view corresponding to the line A-A' of FIG. 3.
FIGS. 7 to 25 are diagrams illustrating a method of fabricating a three-dimensional semiconductor device, according to an embodiment of the disclosure.

### DETAILED DESCRIPTION

Non-limiting example embodiments of the disclosure will now be described more fully with reference to the accompanying drawings, in which example embodiments are shown. Like reference numerals in the drawings denote like elements, and thus repeated description thereof may be omitted.

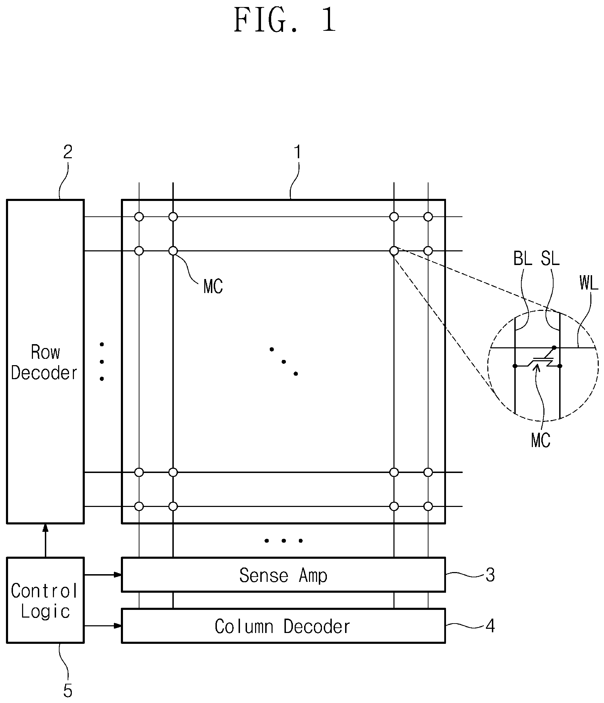

FIG. 1 is a circuit diagram schematically illustrating a three-dimensional semiconductor device according to an embodiment of the disclosure.

Referring to FIG. 1, a three-dimensional semiconductor device may include a memory cell array 1, a row decoder 2, a sense amplifier 3, a column decoder 4, and control logic 5.

The memory cell array 1 may include word lines WL, bit lines BL, source lines SL, and memory cells MC. The memory cells MC may be three-dimensionally arranged, and each memory cell MC may be connected to one of the word lines WL, one of the bit lines BL, and one of the source lines SL. In an embodiment, each of the memory cells MC may be composed of one transistor including a memory layer or a data storing layer.

The row decoder 2 may be configured to decode address information, which is input from the outside, and to select one of the word lines WL of the memory cell array 1, based on the decoded address information. The address information decoded by the row decoder 2 may be provided to a row driver, and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which may be selected based on address information decoded by the column decoder 4, and a reference bit line.

The column decoder 4 may establish a data transmission path between the sense amplifier 3 and an external device (e.g., a memory controller). The column decoder 4 may be configured to decode address information, which is input from the outside, and to select one of the bit lines BL, based on the decoded address information.

The control logic 5 may be configured to generate control signals, which may be used to control data-writing or data-reading operations on the memory cell array 1.

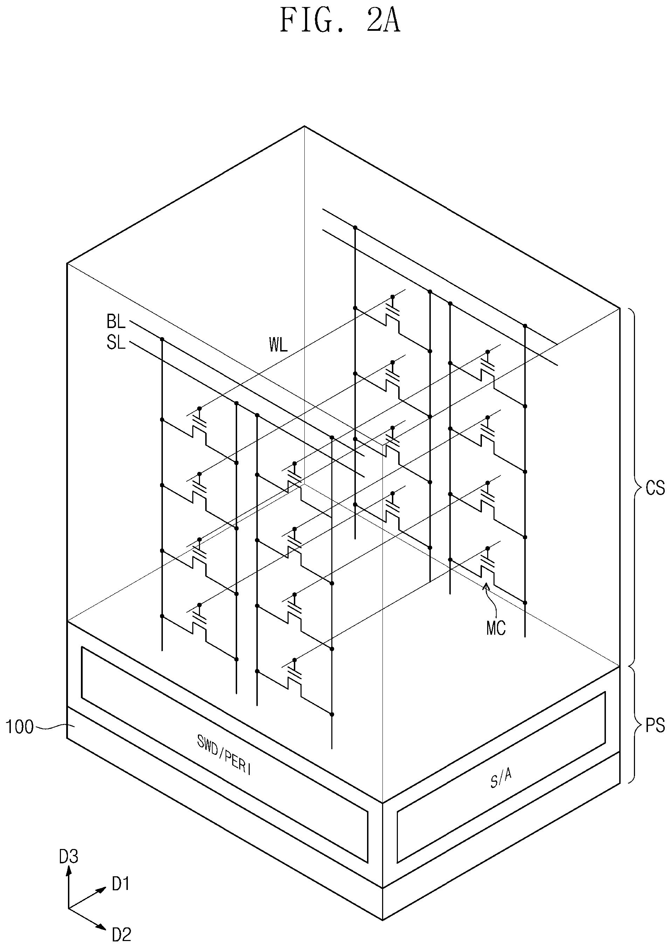

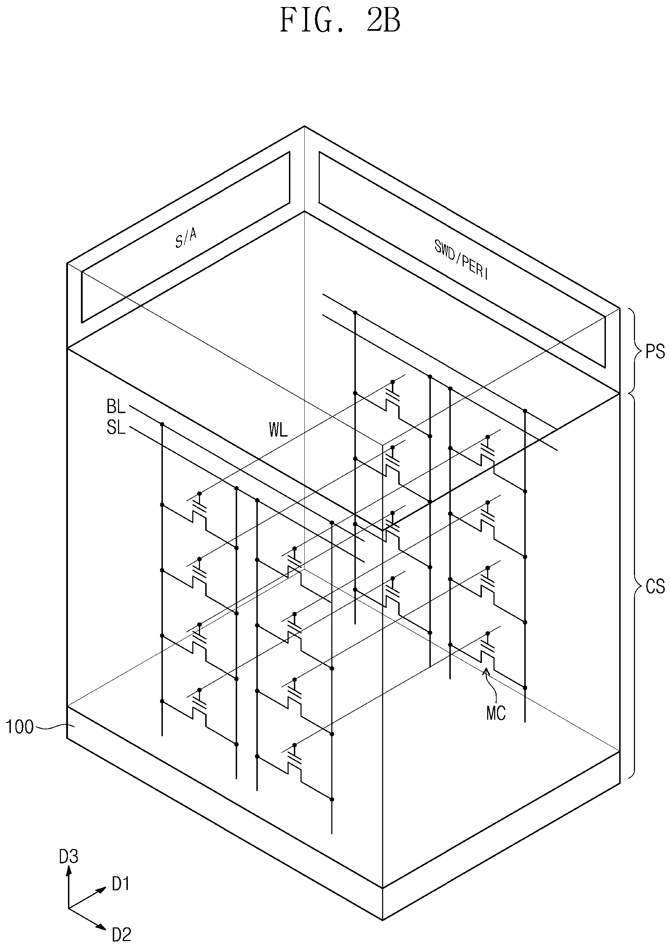

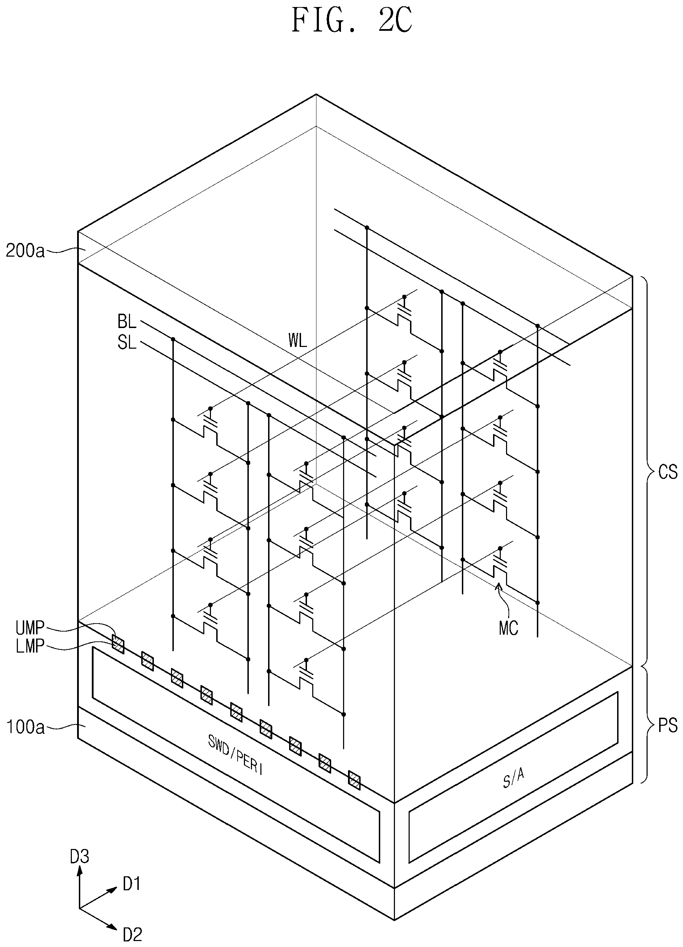

FIGS. 2A, 2B, and 2C are perspective views schematically illustrating a three-dimensional semiconductor device according to an embodiment of the disclosure.

Referring to FIG. 2A, a three-dimensional semiconductor device may include a substrate 100, a peripheral circuit structure PS on the substrate 100, and a cell array structure CS on the peripheral circuit structure PS.

The peripheral circuit structure PS may include core and peripheral circuits, which may be formed on the substrate 100. The core and peripheral circuits may include the row decoder 2, the column decoder 4, the sense amplifier 3, and the control logic 5 described with reference to FIG. 1.

The substrate 100 may be a plate-shaped structure that extends parallel to a plane defined by a first direction D1 and a second direction D2. The first direction D1 and the second direction D2 may be parallel to a top surface of the substrate 100 and may not be parallel to each other. As an example, the first direction D1 and the second direction D2 may be horizontal directions that are orthogonal to each other. The peripheral circuit structure PS and the cell array structure CS may be sequentially stacked on the substrate 100 in a third direction D3 that is perpendicular to the top surface of the substrate 100.

The cell array structure CS may include the bit lines BL, the source lines SL, the word lines WL, and the memory cells MC therebetween. Each of the memory cells MC may be connected to one of the word lines WL, one of the bit lines BL, and one of the source lines SL.

Referring to FIG. 2B, the semiconductor device may include the cell array structure CS on the substrate 100 and the peripheral circuit structure PS on the cell array structure CS. The cell array structure CS may be disposed between the substrate 100 and the peripheral circuit structure PS. The peripheral circuit structure PS may include the core and peripheral circuits.

Referring to FIG. 2C, the semiconductor device may have a chip-to-chip (C2C) structure. The peripheral circuit structure PS may include a first substrate 100a. Lower metal pads LMP may be provided in the uppermost portion of the peripheral circuit structure PS. The lower metal pads LMP may be electrically connected to the core and peripheral circuits. The lower metal pads LMP may be bonded to upper metal pads UMP of the cell array structure CS.

The cell array structure CS may include a second substrate 200a, and the upper metal pads UMP may be provided in the lowermost portion of the cell array structure CS. The upper metal pads UMP may be electrically connected to the bit lines BL, the source lines SL, and the word lines WL. The upper metal pads UMP may be electrically connected to the memory cells MC.

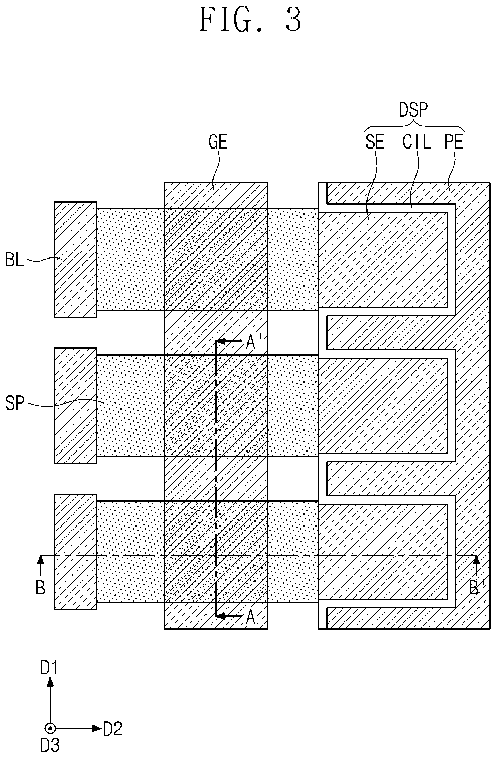

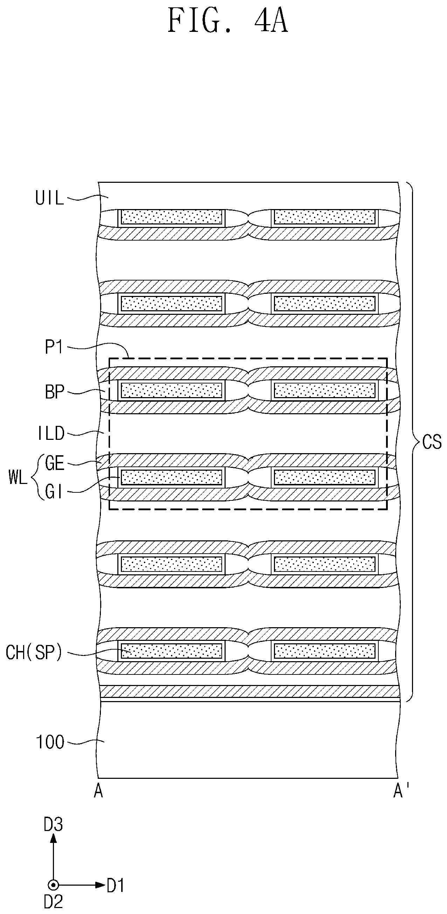

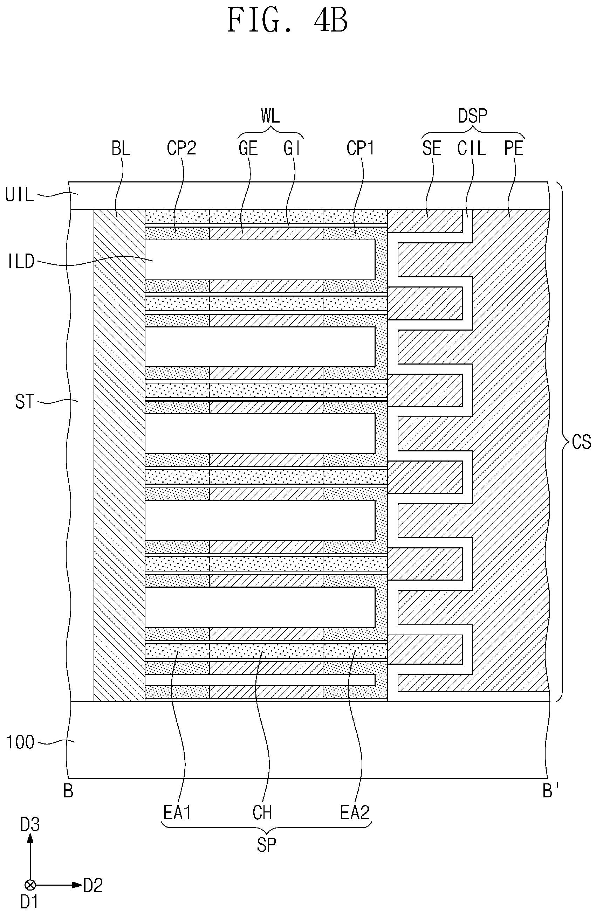

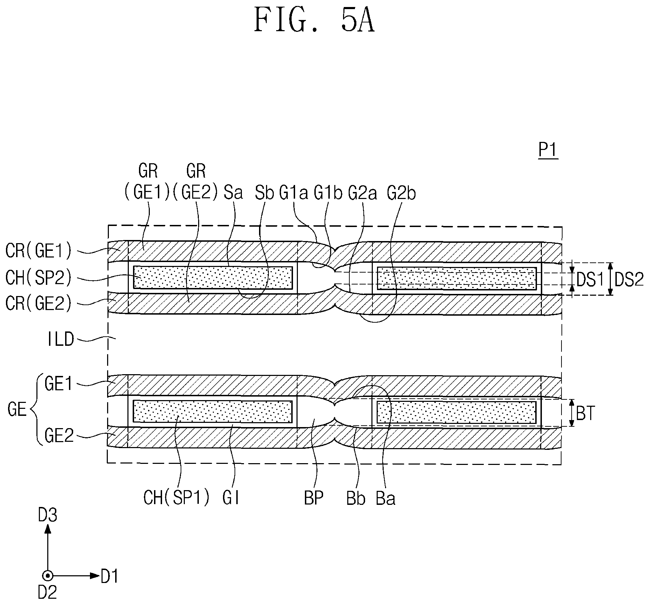

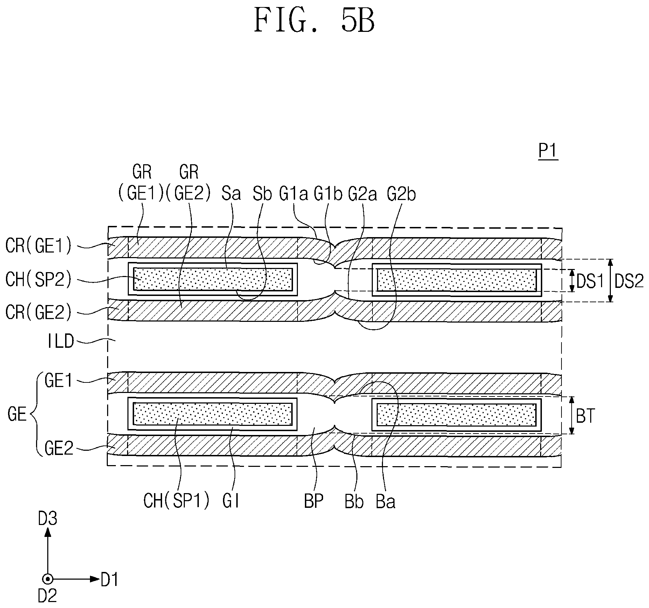

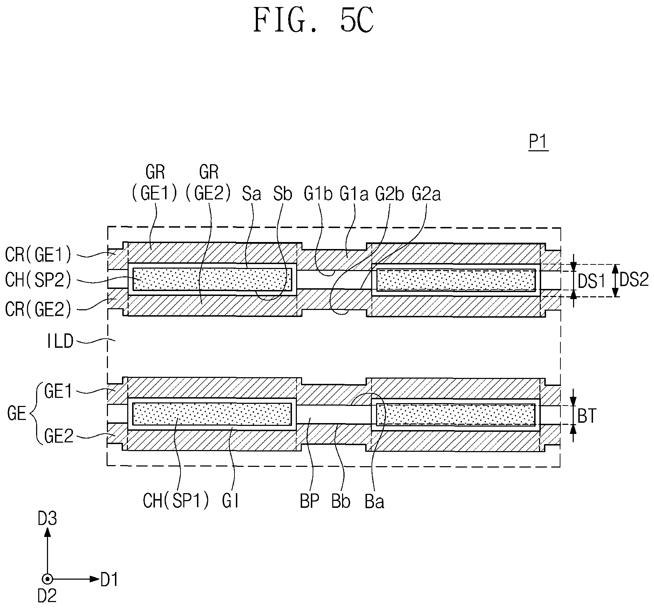

FIG. 3 is a plan view illustrating a three-dimensional semiconductor device according to an embodiment of the disclosure. FIG. 4A is a sectional view corresponding to a line A-A' of FIG. 3. FIG. 4B is a sectional view corresponding to a line B-B' of FIG. 3. FIGS. 5A, 5B, and 5C are enlarged views illustrating a portion P1 of FIG. 4A.

Referring to FIGS. 3, 4A, and 4B, a three-dimensional semiconductor device may include the substrate 100. In an embodiment, the substrate 100 may be a semiconductor substrate, an insulating substrate, a silicon-on-insulator (SOI) substrate, or a germanium-on-insulator (GOI) substrate. The semiconductor substrate may be, for example, a silicon substrate, a germanium substrate, or a silicon-germanium substrate. The substrate 100 may be a plate-shaped structure that extends in the first direction D1 and the second direction D2. The first direction D1 and the second direction D2 may be parallel to the top surface of the substrate 100 and may not be parallel to each other. In an embodiment, the substrate 100 may include the peripheral circuit structure PS described with reference to FIGS. 2A and 2C.

The cell array structure CS may be provided on the substrate 100. The drawings illustrate an example, in which one cell array structure CS is provided on the substrate 100, but embodiments of the disclosure are not limited to this example. For example, the cell array structure CS may be a plurality of cell array structures CS, which are adjacent to each other in the second direction D2. Hereinafter, just one cell array structure CS will be described, for brevity's sake, but the others of the cell array structures CS may also have substantially the same features as described below.

The cell array structure CS may include semiconductor patterns SP, word lines WL, a data storage pattern DSP, and peripheral elements surrounding them. Each of them will be described in more detail below.

The semiconductor pattern SP may be spaced apart from the substrate 100 in the third direction D3. That is, the semiconductor pattern SP may be floated from the substrate 100. The semiconductor pattern SP may extend in the second direction D2, on the substrate 100. In an embodiment, the semiconductor pattern SP may be a bar-shaped pattern extending in the second direction D2.

The semiconductor pattern SP may include a first edge portion EA1 and a second edge portion EA2, which may be spaced apart from each other in the second direction D2, and a channel region CH, which may be provided therebetween. The channel region CH of the semiconductor pattern SP may be vertically overlapped with the word line WL, which will be described below. The first edge portion EA1 of the semiconductor pattern SP may be connected to the bit line BL, which will be described below. The second edge portion EA2 may be connected to the data storage pattern DSP, which will be described below. In the present specification, the expression "elements A and B are connected" may be used to indicate that elements A and B are either directly connected to each other or indirectly connected through another element C (e.g., a conductive element) therebetween. Here, the element C may be a single element or a plurality of elements.

The semiconductor pattern SP may be formed of or include at least one from among single-crystalline semiconductor materials, polycrystalline semiconductor materials, oxide semiconductor materials, and two-dimensional materials. In an embodiment, the single-crystalline semiconductor material may be single-crystalline silicon. In an embodiment, the polycrystalline semiconductor materials may be poly silicon. In an embodiment, the oxide semiconductor materials may be indium gallium zinc oxide (IGZO). In an embodiment, the two-dimensional material may be MoS₂, WS₂, MoSe₂, or WSe₂. In the present specification, each of the expressions of "A or B", "at least one of A and B", "at least one of A or B", "A, B, or C", "at least one of A, B, and C", and "at least one of A, B, or C" may be used to represent one of the elements enumerated in the expression or any possible combination of the enumerated elements.

In an embodiment, each of the first edge portion EA1 and the second edge portion EA2 of the semiconductor pattern SP may include an impurity region doped with impurities (e.g., n- or p-type impurities). The impurity region may constitute a source/drain region of a transistor.

In an embodiment, a plurality of semiconductor patterns SP may be provided. The semiconductor patterns SP may be spaced apart from each other in the first direction D1 and the third direction D3. In an embodiment, the top surfaces of the semiconductor patterns SP, which may extend in the first direction D1, may be aligned to (e.g., coplanar with) each other. The semiconductor patterns SP, which are stacked in the third direction D3, may be vertically overlapped with each other. In an embodiment, the side surfaces of the semiconductor patterns SP, which are stacked in the third direction D3, may be aligned to (e.g., coplanar with) each other.

The word line WL may extend in the first direction D1, on the channel region CH of the semiconductor pattern SP. The word line WL may include a gate insulating pattern GI, which may be provided to enclose the channel region CH of the semiconductor pattern SP, and a gate pattern GE, which may be provided on the gate insulating pattern GI and extend in the first direction D1. The gate pattern GE may be provided in plural as a pair of gate patterns GE, which may be spaced apart from each other in the third direction D3 with the semiconductor pattern SP interposed therebetween. The gate pattern GE may not include a void therein.

In an embodiment, the gate insulating pattern GI may be formed of or include at least one from among high-k dielectric materials, silicon oxide, silicon nitride, and silicon oxynitride, and may be provided to have a single- or multi- layered structure. In the present specification, the high-k dielectric material may be defined as a material having a dielectric constant higher than silicon oxide.

In an embodiment, the gate pattern GE may be formed of or include at least one from among Ti, TiN, TiSiN, TiON, W, WN, Mo, MoN, MoOxNy, Ta, TaN, Poly Si, Li, Na, K, Cs, Rb, Sr, Ba, Ca, Ce, Sm, Eu, Mg, Sc, Y, Hf, Tl, As, La, Nd, Gd, Tb, Lu, Th, U, Mn, Al, Ga, In, Pb, Cd, Bi and Zr. The gate pattern GE may be a single layer or a composite layer.

A bridge pattern BP may be interposed between the semiconductor patterns SP, which are spaced apart from each other in the first direction D1. The bridge pattern BP may be interposed between the pair of gate patterns GE described above. Thus, the pair of gate patterns GE may be spaced apart from each other by the bridge pattern BP.

In an embodiment, the bridge pattern BP may be formed of or include at least one from among SiO2, SiON, SiOC, SiN, SiC, SiBN, C, and CN. In the case where the bridge pattern BP includes the same material as a material of the gate insulating pattern GI, there may be no observable interface between the bridge pattern BP and the gate insulating pattern GI.

In an embodiment, a plurality of bridge patterns BP may be provided. The bridge patterns BP may be spaced apart from each other in the first direction D1. The bridge patterns BP and the semiconductor patterns SP may be alternately arranged in the first direction D1.

An interlayer insulating layer ILD may be interposed between the semiconductor patterns SP, which are spaced apart from each other in the third direction D3, and may extend in the first direction D1. The interlayer insulating layer ILD may include an insulating material.

Referring to FIG. 5A, the plurality of gate patterns GE may include a first gate pattern GE1, which may be provided on top surfaces Sa of the semiconductor patterns SP and extend in the first direction D1, and a second gate pattern GE2, which may be provided on bottom surfaces Sb of the semiconductor patterns SP and extend in the first direction D1. The first gate pattern GE1 and the second gate pattern GE2 may be spaced apart from each other by the bridge pattern BP.

The plurality of semiconductor patterns SP may include a first semiconductor pattern SP1 and a second semiconductor pattern SP2, which may be spaced apart from each other in the third direction D3. The interlayer insulating layer ILD may be interposed between the first gate pattern GE1, which may be on a top surface Sa of the first semiconductor pattern SP1, and the second gate pattern GE2, which may be on a bottom surface Sb of the second semiconductor pattern SP2.

Each of the first gate pattern GE1 and the second gate pattern GE2 may include a gate region GR, which may be vertically overlapped with the semiconductor pattern SP, and an extension region CR, which may be vertically overlapped with the bridge pattern BP.

The extension region CR of the first gate pattern GE1 may protrude to a region lower than the gate region GR of the first gate pattern GE1 (e.g., in the opposite direction of the third direction D3). In addition, the extension region CR of the second gate pattern GE2 may protrude to a region higher than the gate region GR of the second gate pattern GE2 (e.g., in the third direction D3).

A distance DS1 (e.g., a smallest distance) between the extension regions CR of the first gate pattern GE1 and the second gate pattern GE2 may be smaller than a distance DS2 between the gate regions GR of the first gate pattern GE1 and the second gate pattern GE2. The distance DS1 between the extension regions CR of the first gate pattern GE1 and the second gate pattern GE2 may decrease as it moves in the first direction D1 and then increase again. A distance between the extension region CR of the first gate pattern GE1 on the top surface Sa of the first semiconductor pattern SP1 and the extension region CR of the second gate pattern GE2 on the bottom surface Sb of the second semiconductor pattern SP2 may increase as it moves in the first direction D1 and then decrease again.

The extension region CR of the first gate pattern GE1 may have a top surface G1a and a bottom surface G1b that are formed to have a downwardly concave profile. The extension region CR of the second gate pattern GE2 may have a top surface G2a and a bottom surface G2b that are formed to have an upwardly convex profile. The lowermost surface of the extension region CR of the first gate pattern GE1 may be located at a vertical level lower than the top surface Sa of the semiconductor pattern SP. The uppermost surface of the extension region CR of the second gate pattern GE2 may be located at a vertical level higher than the bottom surface Sb of the semiconductor pattern SP. The top surface G1a of the extension region CR of the first gate pattern GE1 may be located at a vertical level lower than a top surface of the gate region GR of the first gate pattern GE1. The bottom surface G1b of the extension region CR of the first gate pattern GE1 may be located at a vertical level lower than a bottom surface of the gate region GR of the first gate pattern GE1. The top surface G2a of the extension region CR of the second gate pattern GE2 may be located at a vertical level higher than a top surface of the gate region GR of the second gate pattern GE2. The bottom surface G2b of the extension region CR of the second gate pattern GE2 may be located at a vertical level higher than a bottom surface of the gate region GR of the second gate pattern GE2.

In an embodiment, each of the first gate pattern GE1 and the second gate pattern GE2 may extend in the first direction D1 to have a wavy shape.

A thickness BT of the bridge pattern BP may decrease as it moves in the first direction D1 and then increase again. A minimum thickness of the bridge pattern BP may be smaller than a thickness of the semiconductor pattern SP. A top surface of the bridge pattern BP may have a downwardly concave profile. A bottom surface of the bridge pattern BP may have an upwardly convex profile.

The interlayer insulating layer ILD may include protruding portions, which may extend in the third direction D3 and the opposite direction thereof. The protruding portions of the interlayer insulating layer ILD may be repeatedly disposed in the first direction D1.

Referring to FIG. 5B, the first gate pattern GE1 and the second gate pattern GE2 may have the same or similar shape as that in FIG. 5A. Unlike the structure of FIG. 5A, the bridge pattern BP may be provided to enclose the channel region CH of the semiconductor pattern SP and to extend in the first direction D1. The bridge pattern BP may be provided to enclose the gate insulating pattern GI and extend in the first direction D1. Thus, a portion of the bridge pattern BP may be interposed between the semiconductor pattern SP and the first gate pattern GE1 and between the semiconductor pattern SP and the second gate pattern GE2.

The uppermost surface of the bridge pattern BP may be located at a vertical level higher than a top surface of the gate insulating pattern GI. The lowermost surface of the bridge pattern BP may be located at a vertical level lower than a bottom surface of the gate insulating pattern GI. Each of the first gate pattern GE1 and the second gate pattern GE2 may be spaced apart from the gate insulating pattern GI by the bridge pattern BP.

Referring to FIG. 5C, the top surface G1a of the extension region CR of the first gate pattern GE1 may have a stepwise portion. The bottom surface G2b of the extension region CR of the second gate pattern GE2 may have a stepwise portion. In an embodiment, the bottom surface G1b of the extension region CR of the first gate pattern GE1 and the top surface G2a of the extension region CR of the second gate pattern GE2 may have a flat profile, in which any stepwise portion is absent.

The distance DS1 between the extension regions CR of the first gate pattern GE1 and the second gate pattern GE2 may be smaller than the distance DS2 between the gate regions GR of the first gate pattern GE1 and the second gate pattern GE2. The distance DS1 between the extension regions CR of the first gate pattern GE1 and the second gate pattern GE2 may be substantially constant, when measured in the first direction D1.

The thickness BT of the bridge pattern BP may be substantially constant, when measured in the first direction D1.

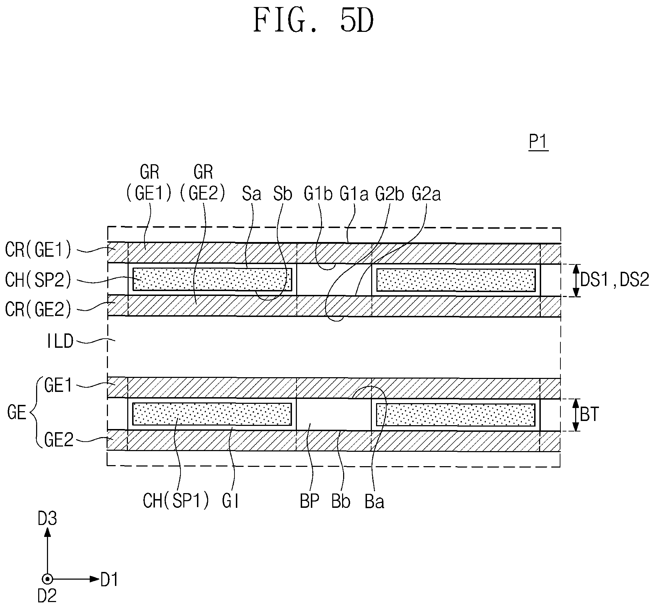

Referring to FIG. 5D, the distance DS1 between the extension regions CR of the first gate pattern GE1 and the second gate pattern GE2 may be substantially equal to the distance DS2 between the gate regions GR of the first gate pattern GE1 and the second gate pattern GE2. The bottom surface G1b of the extension region CR of the first gate pattern GE1 may be located at a vertical level higher than the top surface Sa of the semiconductor pattern SP. The top surface G2a of the extension region CR of the second gate pattern GE2 may be located at a vertical level lower than the bottom surface Sb of the semiconductor pattern SP.

Referring back to FIGS. 3, 4A, and 4B, the bit line BL may extend in the third direction D3, on a side surface of the first edge portion EA1 of the semiconductor pattern SP. Accordingly, each of the bit lines BL may be connected to the side surfaces of the first edge portions EA1 of the semiconductor patterns SP, which are adjacent to each other in the third direction D3. In an embodiment, a plurality of bit lines BL may be provided. The bit lines BL may be disposed to be spaced apart from each other in the second direction D2.

The bit line BL may be a single layer, which may be formed of a single material, or a composite layer, which may be formed of two or more materials. In an embodiment, the bit line BL may be formed of or include at least one from among metallic materials (e.g., Ti, Mo, W, Cu, Al, Ta, Ru, Ir, and Co), metal nitride materials (e.g., nitride materials containing Ti, Mo, W, Cu, Al, Ta, Ru, Ir, and Co), and metal silicide materials (e.g., silicide materials containing Ti, Mo, W, Cu, Al, Ta, Ru, Ir, and Co).

The data storage pattern DSP may extend in the third direction D3, on a side surface of the second edge portion EA2 of the semiconductor pattern SP. Thus, each of the data storage patterns DSP may be connected to the side surfaces of the second edge portions EA2 of the semiconductor patterns SP, which are adjacent to each other in the third direction D3.

The data storage pattern DSP may include a storage electrode SE, a plate electrode PE, and a dielectric layer CIL therebetween. In an embodiment, the three-dimensional semiconductor device may be a dynamic random access memory (DRAM) device, and the data storage pattern DSP may be used as a capacitor. The storage electrode SE may be spaced apart from the plate electrode PE by the dielectric layer CIL.

Each of the storage electrode SE and the plate electrode PE may include a conductive material. In an embodiment, each of the storage electrode SE and the plate electrode PE may be formed of or include at least one from among doped silicon (Si), doped silicon germanium (SiGe), metallic materials (e.g., Ti, Mo, W, Cu, Al, Ta, Ru, Ir, Co, Pt, Au, and Ag), metal nitride materials (e.g., nitride materials containing Ti, Mo, W, Cu, Al, Ta, Ru, Ir, Co, Pt, Au, and Ag), titanium silicon nitride (e.g., TiSiN), titanium aluminum nitride (e.g., TiAlN), tantalum aluminum nitride (e.g., TaAlN), conductive oxide materials (e.g., PtO, RuO₂, IrO₂, SrRuO₃ (SRO), (Ba,Sr)RuO₃ (BSRO), CaRuO₃ (CRO), and LSCo), and metal silicide materials. Each of the storage electrode SE and the plate electrode PE may be a single layer, which may be made of a single material, or a composite layer including two or more materials.

In an embodiment, the dielectric layer CIL may include at least one from among metal oxide materials (e.g., HfO₂, ZrO₂, Al₂O₃, La₂O₃, Ta₂O₃, and TiO₂) and perovskite dielectric materials (e.g., SrTiO₃ (STO), (Ba,Sr)TiO₃ (BST), BaTiO₃, PZT, and PLZT).

In another embodiment, the data storage pattern DSP may be a variable resistance pattern whose resistance can be switched to one of at least two states by an electric pulse applied thereto. For example, the data storage pattern DSP may be formed of or include at least one from among phase-change materials whose crystal state can be changed depending on an amount of a current applied thereto, perovskite compounds, transition metal oxides, magnetic materials, ferromagnetic materials, and antiferromagnetic materials.

According to some embodiments of the disclosure, a silicide pattern may be provided between the storage electrode SE and the semiconductor pattern SP. The silicide pattern may be formed of or include a metal silicide material (e.g., containing at least one of Ti, Mo, W, Cu, Al, Ta, Ru, Ir, or Co). In an embodiment, a plurality of storage electrodes SE may be provided to be adjacent to each other in the third direction D3.

The plate electrode PE may include a first region, which may extend in the third direction D3, and second regions, which may extend from the first region in a direction opposite of the second direction D2. The second regions of the plate electrode PE may be interposed between the storage electrodes SE, which are arranged in the third direction D3.

A first capping pattern CP1 may be interposed between the gate pattern GE and the data storage pattern DSP. In an embodiment, the first capping pattern CP1 may be formed of or include at least one from among SiN, SiO₂, SiC, SiOC, SiON, and SiBN. Accordingly, the gate pattern GE may be spaced apart from and electrically disconnected (e.g., electrically insulated) from the data storage pattern DSP by the first capping pattern CP1. In an embodiment, the first capping pattern CP1 may be provided to conformally and continuously cover a bottom surface of one of a pair of the semiconductor patterns SP, which are adjacent to each other in the third direction D3, the dielectric layer CIL of the data storage pattern DSP, and a top surface of the other of the pair of semiconductor patterns SP.

A second capping pattern CP2 may be interposed between the gate pattern GE and the bit line BL. In an embodiment, the second capping pattern CP2 may be formed of or include at least one from among SiN, SiO₂, SiC, SiOC, SiON, or SiBN. Thus, the gate pattern GE may be spaced apart from and electrically disconnected (e.g., electrically insulated) from the bit line BL by the second capping pattern CP2.

Each of the first capping pattern CP1 and the second capping pattern CP2 may be formed of or include a material having an etch selectivity with respect to the bridge pattern BP.

A device isolation pattern ST may be formed on the substrate 100. The device isolation pattern ST may cover a side surface of the bit line BL. In an embodiment, the device isolation pattern ST may be interposed between adjacent ones of the cell array structures CS. Accordingly, the adjacent ones of the cell array structures CS may be spaced apart from each other by the device isolation pattern ST.

An upper insulating layer UIL may be provided in an upper portion of the cell array structure CS. The upper insulating layer UIL may be provided on a top surface of each of the bit line BL and the data storage pattern DSP. The upper insulating layer UIL may be formed of or include at least one of insulating materials and may have a single- or multi-layered structure. According to embodiments of the disclosure, a plurality of upper interconnection lines may be provided in the upper insulating layer UIL. Some of the upper interconnection lines may be connected to the bit line BL, and others may be connected to the data storage pattern DSP. Word line pads may be provided on a side surface of the cell array structure CS and may be connected to the word lines WL.

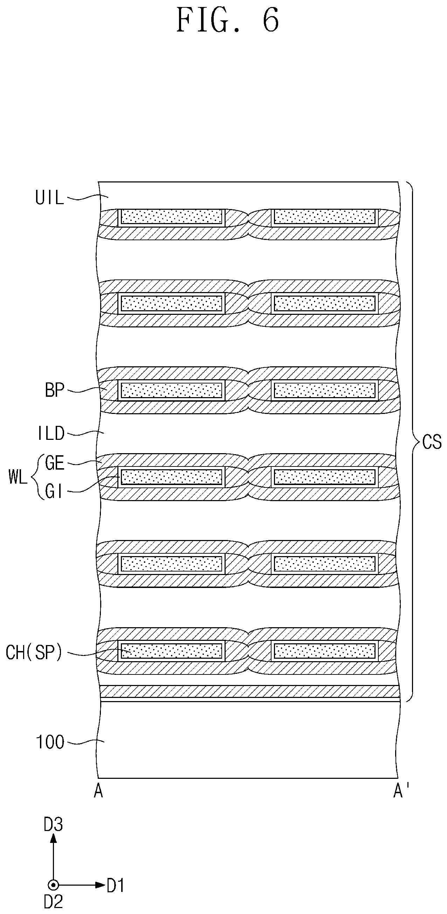

FIG. 6 is a sectional view corresponding to the line A-A' of FIG. 3.

Referring to FIGS. 3 and 6, the bridge pattern BP may include a conductive material, unlike as described with reference to FIGS. 3, 4A, and 4B. In an embodiment, the bridge pattern BP may be formed of or include at least one from among TiN, TaN, WN, W, and Ti. Since the bridge pattern BP includes the conductive material, the gate pattern GE and the gate insulating pattern GI, along with the bridge pattern BP, may constitute the word line WL.

In the case where the bridge pattern BP includes a material different from the gate pattern GE, there may be an observable interface therebetween. However, in the case where the bridge pattern BP includes the same material as the gate pattern GE, there may be no observable interface therebetween.

In the case where the bridge pattern BP and the gate pattern GE include a conductive material, the word line WL may be provided to enclose the channel region CH of the semiconductor pattern SP and to extend in the first direction D1. In an embodiment, the word line WL may have a structure fully surrounding the channel region CH of the semiconductor pattern SP (e.g., a gate-all-around structure). Each of the word lines WL may be provided to enclose the channel region CH of each of the semiconductor patterns SP, which are spaced apart from each other in the first direction D1.

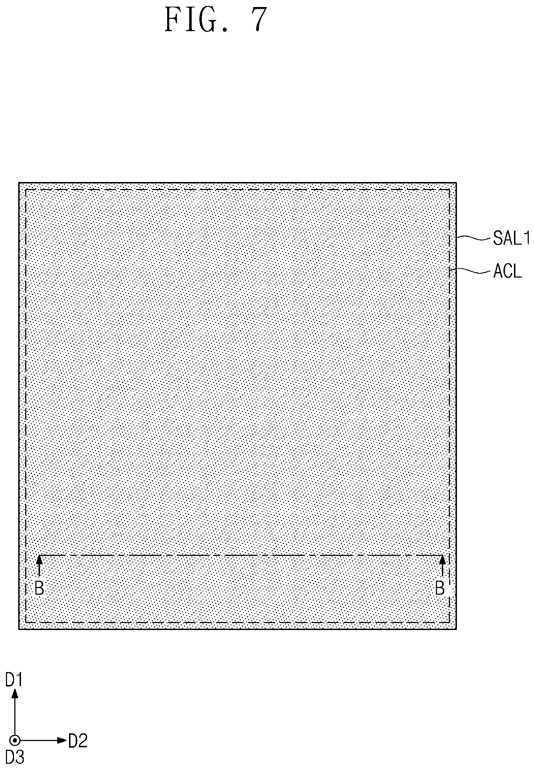

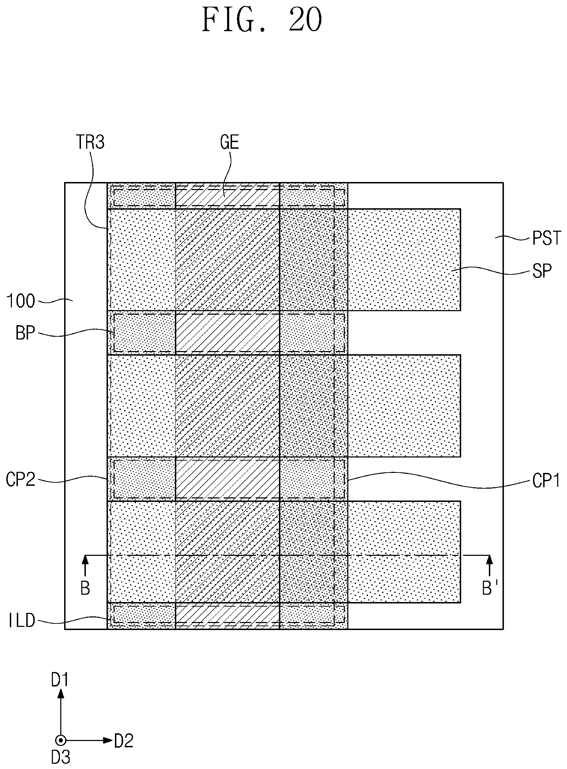

Hereinafter, a method of fabricating a three-dimensional semiconductor device, according to an embodiment of the disclosure, will be described in more detail with reference to FIGS. 7 to 25. In the following description, a previously-described element may be identified by the same reference number without repeating an overlapping description thereof, for concise description.

FIGS. 7 to 21 are diagrams illustrating a method of fabricating a three-dimensional semiconductor device, according to an embodiment of the disclosure. In detail,

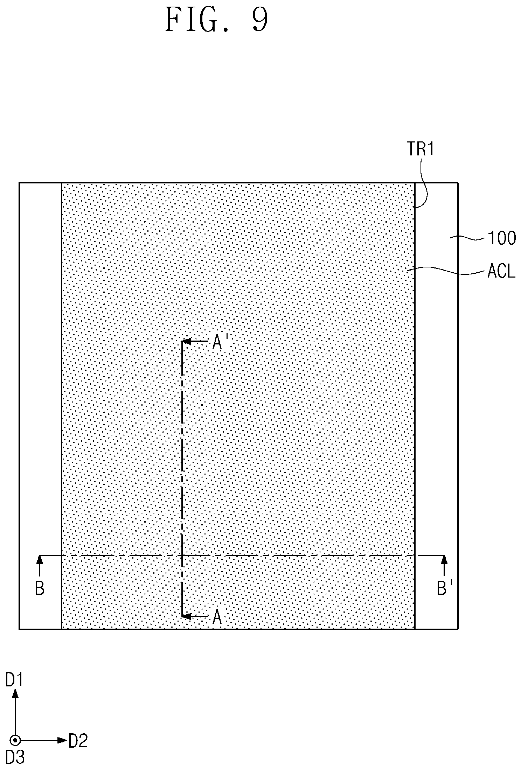

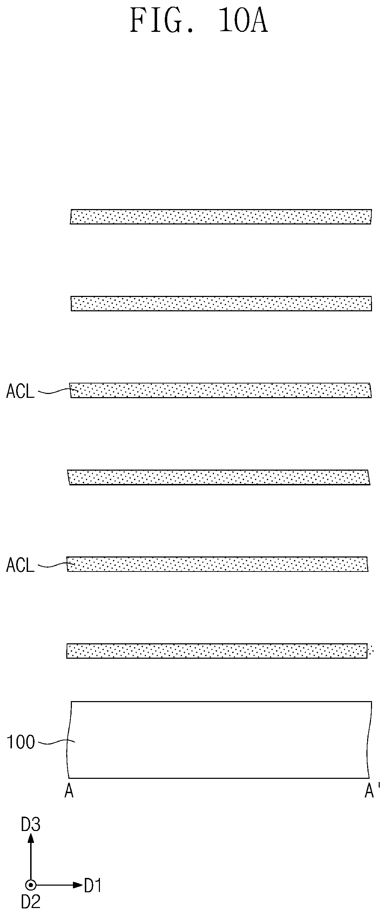

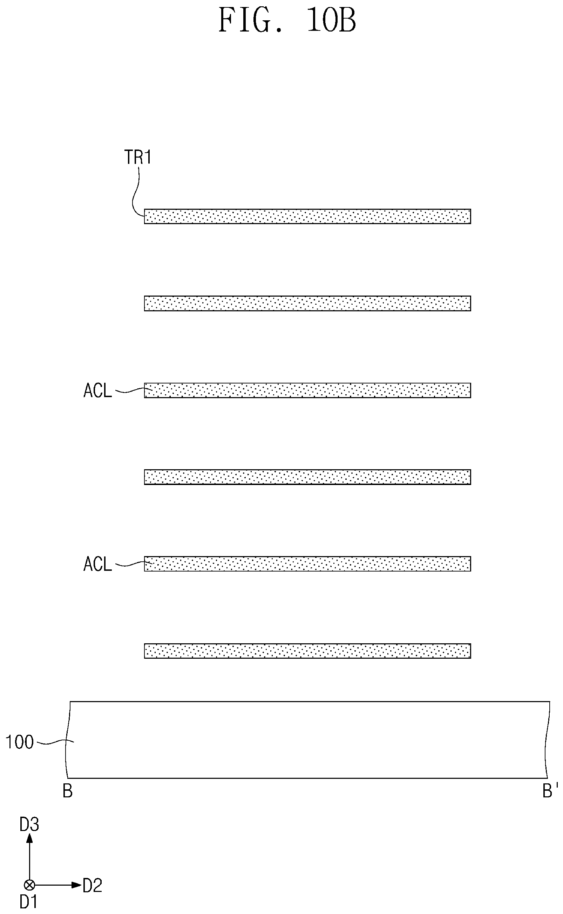

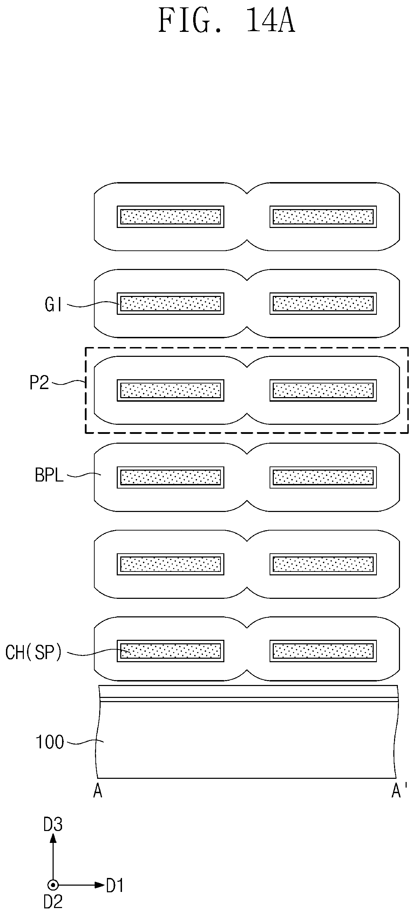

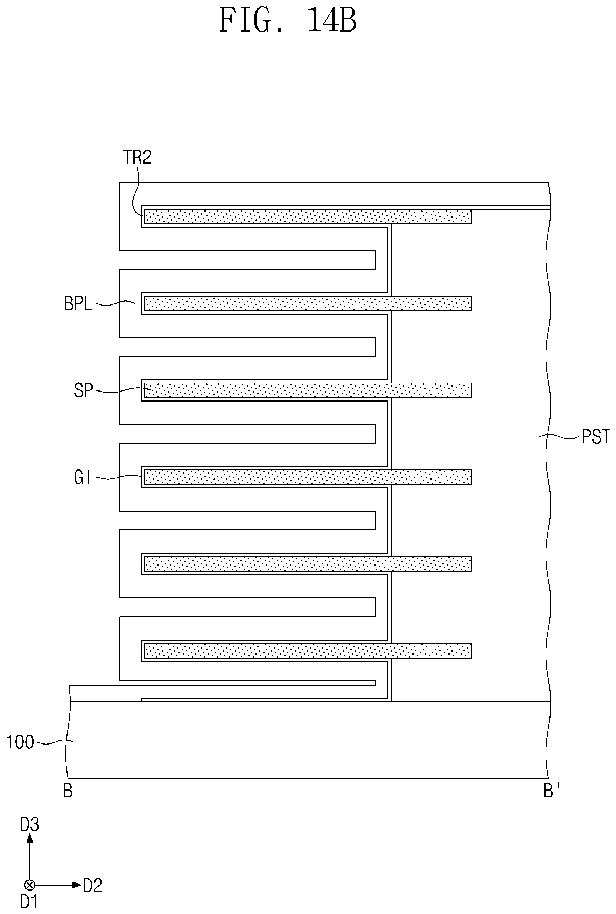

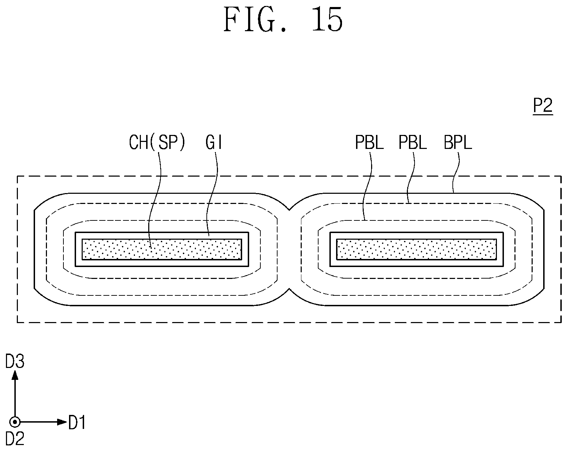

FIGS. 7, 9, 11, 13, 16, 18, and 20 are plan views illustrating a three-dimensional semiconductor device according to an embodiment of the disclosure. FIGS. 10A, 12A, 14A, 17A, and 19A are sectional views taken along lines A-A' of FIGS. 9, 11, 13, 16, and 18, respectively. FIGS. 10B, 12B, 14B, 17B, 19B, and 21 are sectional views taken along lines B-B' of FIGS. 9, 11, 13, 16, 18 and 20 respectively. FIG. 15 is an enlarged view corresponding to a portion P2 of FIG. 14A.

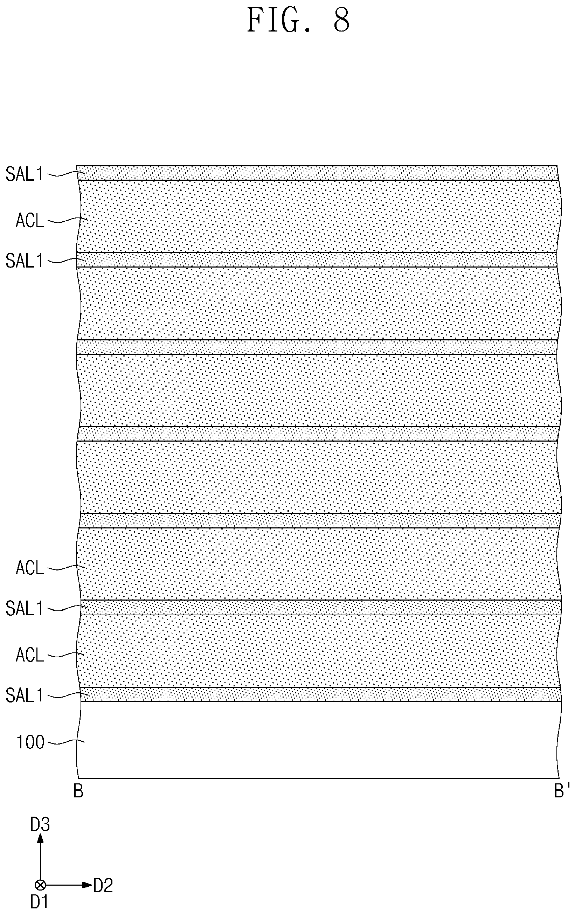

Referring to FIGS. 7 and 8, the substrate 100 may be prepared. A stack, in which first sacrificial layers SAL1 and active layers ACL are alternately stacked, may be formed on the substrate 100. Each of the first sacrificial layers SAL1 and the active layers ACL may include a semiconductor material. The first sacrificial layers SAL1 may include a material having an etch selectivity with respect to the active layers ACL. Thus, the active layers ACL may remain unremoved or be removed only slightly, even when the first sacrificial layers SAL1 are removed in a subsequent removal process. In an embodiment, the active layers ACL and the first sacrificial layers SAL1 may be formed of or include at least one from among silicon (Si), germanium (Ge), and silicon germanium (SiGe), but the material of the first sacrificial layers SAL1 may be different from the material of the active layers ACL. In an embodiment, the active layers ACL may include silicon (Si), and the first sacrificial layers SAL1 may include silicon-germanium (SiGe). When measured in the third direction D3, a thickness of the first sacrificial layers SAL1 may be smaller than a thickness of the active layers ACL.

According to some embodiments of the disclosure, a supporter pattern may be further provided to penetrate the stack. Since the supporter pattern is in contact with the stack, the supporter pattern may be used to support the stack in a subsequent removal process on the first sacrificial layers SAL1 or the active layers ACL. As a result, the supporter pattern may prevent the stack from being collapsed during the fabrication process.

Referring to FIGS. 9, 10A, and 10B, a removal process may be performed on a portion of the stack. Accordingly, a first trench TR1 may be formed on opposite side surfaces of the stack. The first sacrificial layers SAL1 of FIG. 8 may be removed from the substrate 100 through the first trench TR1. Next, a removal process may be performed on a portion of each of the active layers ACL. Thus, the thickness of each of the active layers ACL may be reduced.

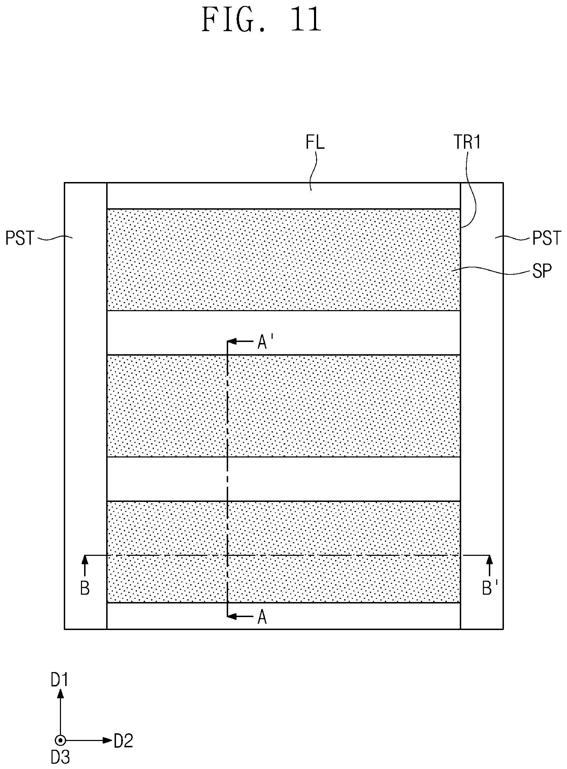

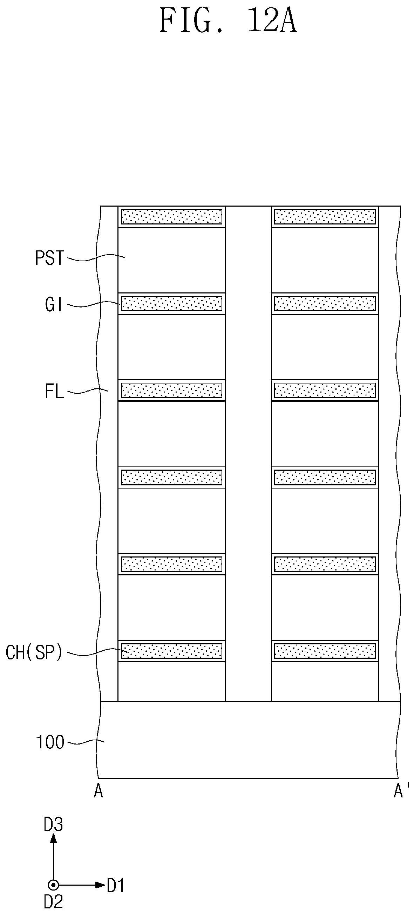

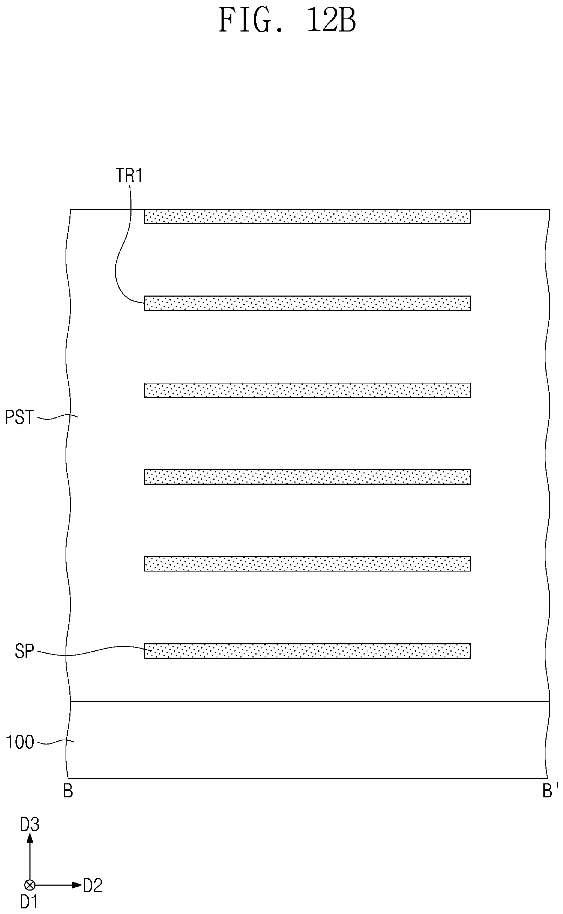

Referring to FIGS. 11, 12A, and 12B, a preliminary device isolation pattern PST may be formed to fill a space within the first trench TR1 and between the active layers ACL. Thereafter, a removal process may be performed on a portion of each of the active layers ACL. A portion of the preliminary device isolation pattern PST, which is vertically overlapped with the removed portions of the active layers ACL, may also be removed when the removal process is performed. Accordingly, each of the active layers ACL may be divided into the semiconductor patterns SP, which are spaced apart from each other in the first direction D1. A filling pattern FL may be formed in an empty region, which is formed by the removal process.

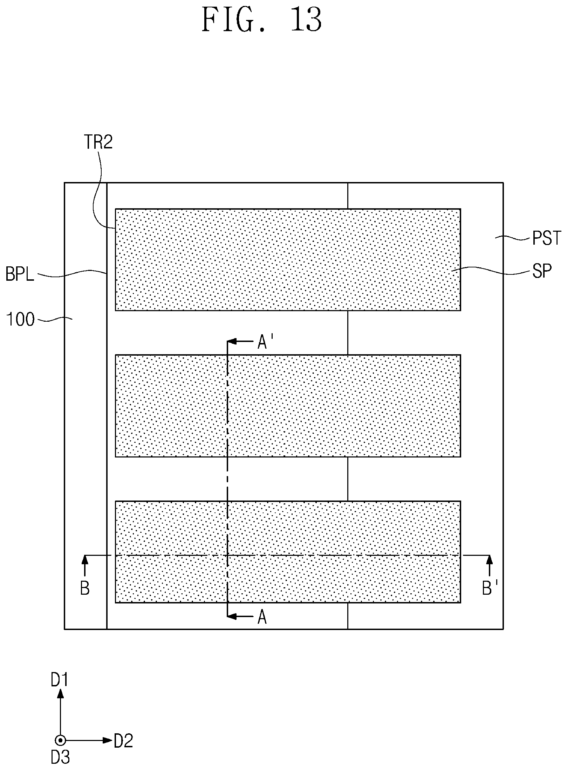

Referring to FIGS. 13, 14A, 14B, and 15, a second trench TR2 may be formed by removing a portion of the preliminary device isolation pattern PST on a side surface of the stack.

In an embodiment, the filling pattern FL of FIG. 12A and a portion of the preliminary device isolation pattern PST, which is interposed between the semiconductor patterns SP in the third direction D3, may be removed through the second trench TR2.

Next, the gate insulating pattern GI may be formed to conformally cover the semiconductor patterns SP. Thereafter, a bridge layer BPL may be formed to conformally enclose the channel regions CH of the semiconductor patterns SP, which are spaced apart from each other in the first direction D1, and to extend in the first direction D1. The bridge layer BPL may be formed to cover the semiconductor patterns SP, which are spaced apart from each other in the third direction D3. The bridge layer BPL may be formed to fill a space between the semiconductor patterns SP, which are spaced apart from each other in the first direction D1. In an embodiment, the bridge layer BPL may include an insulating material. For example, the bridge layer BPL may be formed of or include at least one from among SiO₂, SiON, SiOC, SiN, SiC, SiBN, C, and CN.

Referring to FIG. 15, a preliminary bridge layer PBL may be formed to conformally enclose the channel regions CH of the semiconductor patterns SP, which are spaced apart from each other in the first direction D1. As the height and width of the preliminary bridge layer PBL increase, the preliminary bridge layers PBL, which are formed on the channel regions CH of the semiconductor patterns SP spaced apart from each other in the first direction D1, may be connected to each other. Thus, the bridge layer BPL may be formed to fill the space between the semiconductor patterns SP, which are spaced apart from each other in the first direction D1. Since the preliminary bridge layers PBL are conformally formed on the semiconductor pattern SP until they are in contact with each other, the preliminary bridge layers PBL may form a curved portion at a region where they meet each other. Accordingly, the preliminary bridge layer PBL may be formed to have a top surface having a downwardly concave profile and a bottom surface having an upwardly convex profile. In an embodiment, the process of forming and growing the preliminary bridge layer PBL may be performed through a single deposition process.

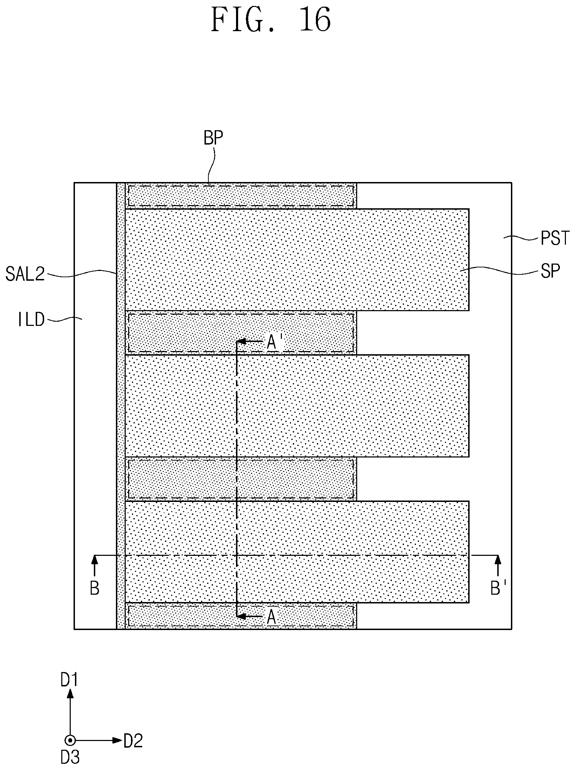

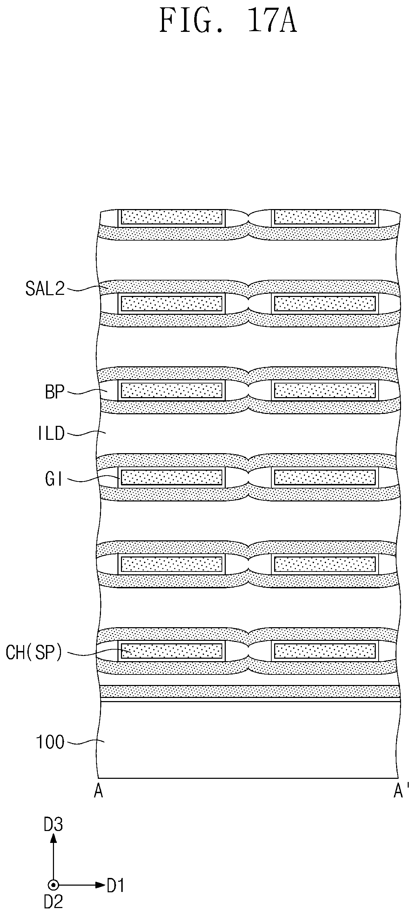

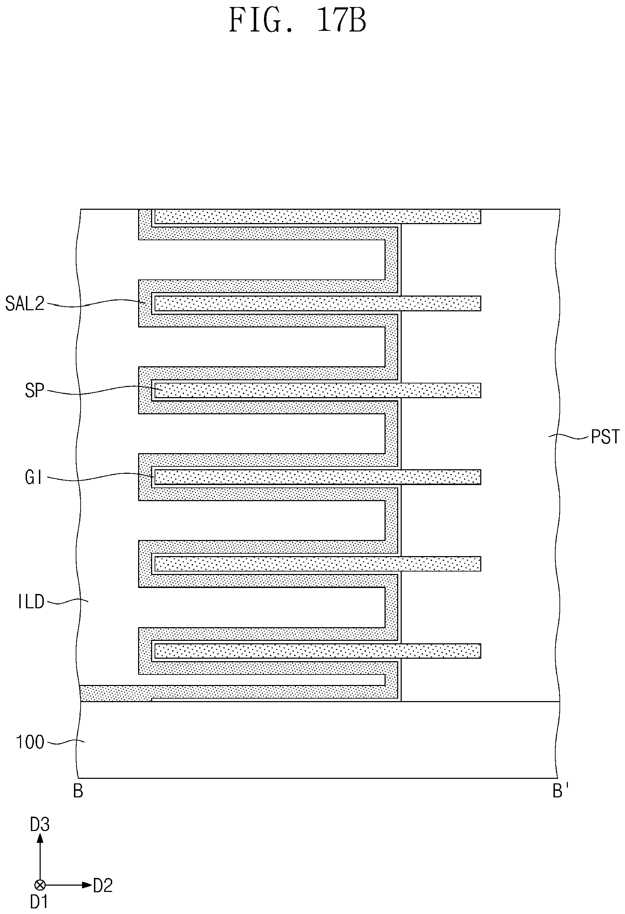

Referring to FIGS. 16, 17A, and 17B, a removal process may be performed on a portion of the bridge layer BPL of FIG. 15. Thus, only portions of the bridge layer BPL of FIG. 15 may be left in the space between the semiconductor patterns SP, which are spaced apart from each other in the first direction D1. The portions of the bridge layer BPL of FIG. 15 that are left may form the bridge patterns BP. For example, in the case where there is an observable interface between the bridge layer BPL of FIG. 15 and the gate insulating pattern GI, the bridge layer BPL of FIG. 15 may be divided into the bridge patterns BP, which are spaced apart from each other in the first direction D1, by the removal process.

In an embodiment, the bridge layer BPL of FIG. 15 may be formed of or include a material having an etch selectivity with respect to the gate insulating pattern GI. Accordingly, the gate insulating pattern GI may remain unremoved or be removed only slightly, when the bridge layer BPL of FIG. 15 is removed. Here, the removal process may be performed to expose the top and bottom surfaces of the gate insulating pattern GI, but embodiments of the disclosure are not limited to this example.

In another embodiment, the removal process may be performed to remove the gate insulating pattern GI on the top and bottom surfaces of the channel region CH of the semiconductor pattern SP and to expose the top and bottom surfaces of the channel region CH. In this case, the gate insulating pattern GI may be formed again on the top and bottom surfaces of the channel region CH through a subsequent oxidation process.

In an embodiment, the removal process may be performed in a wet etching manner, and the thickness of the bridge layer BPL of FIG. 15 may be controlled by adjusting a process time. The curved portion of the top and bottom surfaces of the bridge layer BPL of FIG. 15 may still remain, even when the removal process is finished.

Thereafter, a second sacrificial layer SAL2 may be formed on each of the top and bottom surfaces of the semiconductor patterns SP to extend in the first direction D1. The second sacrificial layer SAL2 may be formed to conformally cover the side surface of the preliminary device isolation pattern PST. The second sacrificial layer SAL2 may be formed to conformally cover the exposed top, bottom, and side surfaces of the semiconductor patterns SP and the side surface of the preliminary device isolation pattern PST and to extend in the third direction D3. The second sacrificial layer SAL2 may include a material having an etch selectivity with respect to the bridge patterns BP. In an embodiment, the second sacrificial layer SAL2 may be formed of or include at least one from among SiN, SiO₂, SiC, SiOC, SiON, and SiBN.

Next, the interlayer insulating layer ILD may be formed on the substrate 100. The interlayer insulating layer ILD may be formed on the second sacrificial layer SAL2. The interlayer insulating layer ILD may be formed between the semiconductor patterns SP, which are spaced apart from each other in the third direction D3.

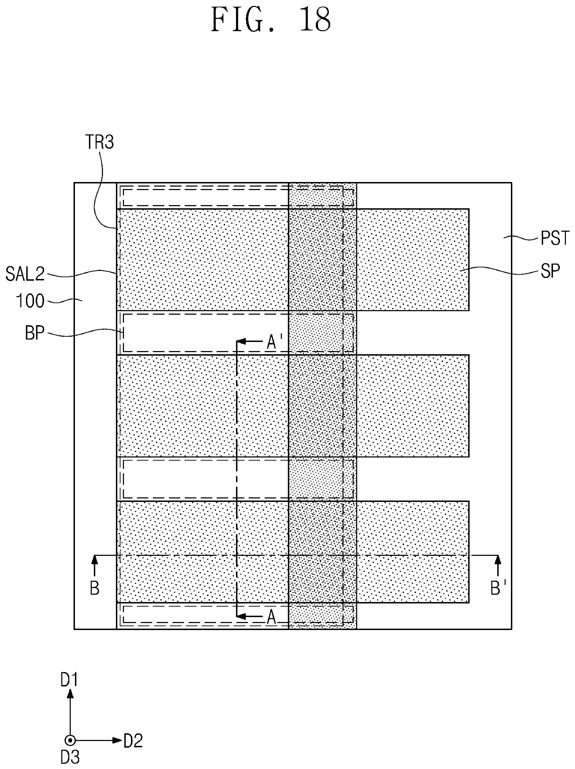

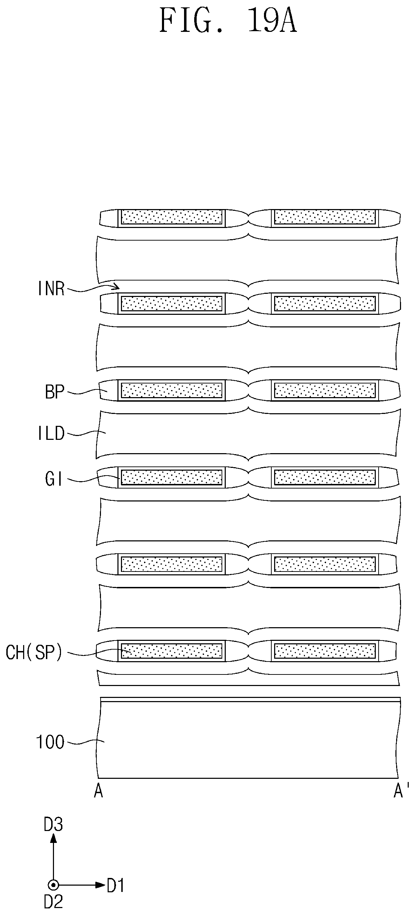

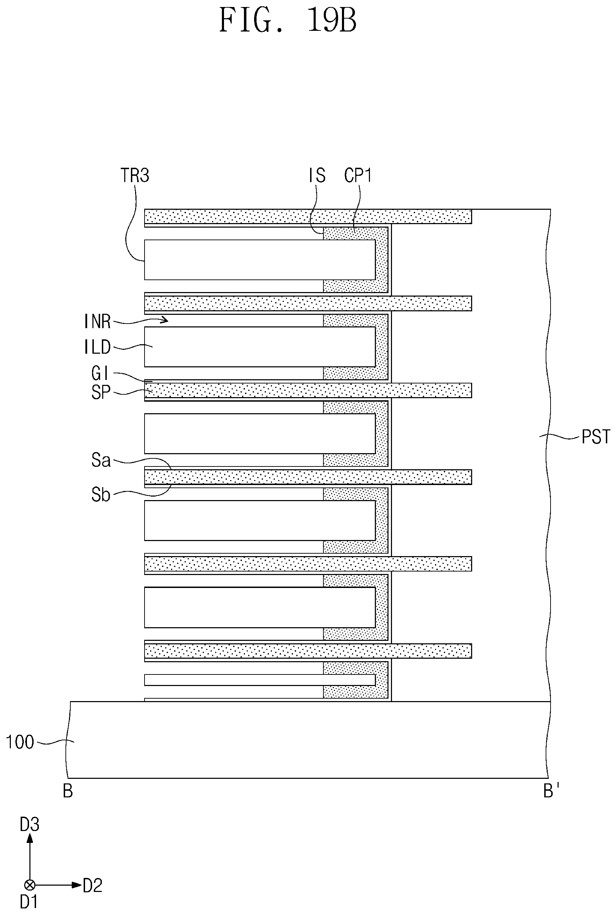

Referring to FIGS. 18, 19A, and 19B, a removal process may be performed on a portion of the interlayer insulating layer ILD. Thus, a third trench TR3 may be formed on the substrate 100. As a result of the removal process, the second sacrificial layer SAL2 of FIG. 17B may be divided into a plurality of second sacrificial layers SAL2 (e.g., of FIG. 17B), which are spaced apart from each other in the third direction D3. As a result of the removal process, side surfaces of each of the semiconductor patterns SP may be exposed to the outside.

Each of the second sacrificial layers SAL2 of FIG. 17B may be partially removed through the third trench TR3. For example, internal regions INR may be formed by partially removing the second sacrificial layers SAL2 of FIG. 17B. Remaining portions of the second sacrificial layers SAL2 of FIG. 17B may form the first capping patterns CP1. In the internal regions INR, side surfaces IS of the first capping patterns CP1 may be exposed to the outside. Each of the internal regions INR may be formed on the top surface Sa of the semiconductor pattern SP. Each of the internal regions INR may be formed on the bottom surface Sb of the semiconductor pattern SP.

According to some embodiments of the disclosure, an additional process may be performed to increase the thickness of the gate insulating pattern GI, after the formation of the internal regions INR. Alternatively, a portion of the gate insulating pattern GI may also be removed when the internal regions INR is formed. Thus, the top and bottom surfaces of the channel region CH of the semiconductor pattern SP may be exposed. In this case, an oxidation process may be performed to form the gate insulating pattern GI on the top and bottom surfaces of the channel region CH again.

Referring to FIGS. 4A, 20, and 21, gate patterns GE may be formed in the internal regions INR described with reference to FIGS. 18, 19A, and 19B. The gate patterns GE may be formed on the exposed side surfaces IS of the first capping patterns CP1. In an embodiment, the formation of the gate patterns GE may include forming a gate layer to fill the internal regions INR and performing a removal process on the gate layer to separate the gate patterns GE, which are formed to partially fill the internal regions INR, from each other.

The extension region CR of the gate pattern GE may have at least one of the shapes shown in FIGS. 5A to 5C, depending on the shape of the bridge pattern BP. The first gate pattern GE1 may be formed in the internal space INR of FIG. 19B, which is formed on the top surface Sa of the semiconductor pattern SP. The second gate pattern GE2 may be formed in the internal space INR of FIG. 19B, which is formed on the bottom surface Sb of the semiconductor pattern SP.

The second capping pattern CP2 may be formed on a side surface of the gate pattern GE. The second capping pattern CP2 may be formed to fill a remaining portion of the internal space INR of FIG. 19B.

According to an embodiment of the disclosure, the processes of forming and removing the bridge layer BPL may be performed before the process of forming the second sacrificial layer SAL2 of FIG. 17A, and in this case, the bridge pattern BP may be formed to fill the space between the semiconductor patterns SP, which are spaced apart from each other in the first direction D1. Accordingly, the second sacrificial layer SAL2 of FIG. 17A may be formed on each of the top and bottom surfaces of the semiconductor patterns SP to extend in the first direction D1, without filling the space between the semiconductor patterns SP. As a result, a void may not be formed in the gate pattern GE, when the gate pattern GE is formed in an empty region formed by removing the second sacrificial layer SAL2 of FIG. 17A through an intaglio process.

By contrast, if the bridge pattern BP is not provided, the second sacrificial layer SAL2 of FIG. 17A may extend in the first direction D1 to enclose the semiconductor patterns SP and may be formed to fill the space between the semiconductor patterns SP. Next, if the gate pattern GE is formed by replacing the second sacrificial layer SAL2 of FIG. 17A, the gate pattern GE may include a void formed between the semiconductor patterns SP. Due to the presence of the void, the gate pattern GE, which is extended in the first direction D1, may be cut, and this may lead to a process failure. In addition, due to the presence of the void, the electric characteristics of the gate pattern GE may be deteriorated.

According to an embodiment of the disclosure, since the bridge pattern BP is provided, it may be possible to prevent the process failure and the deterioration of the electric characteristics described above. Thus, it may be possible to improve the productivity and electric characteristics of the three-dimensional semiconductor device.

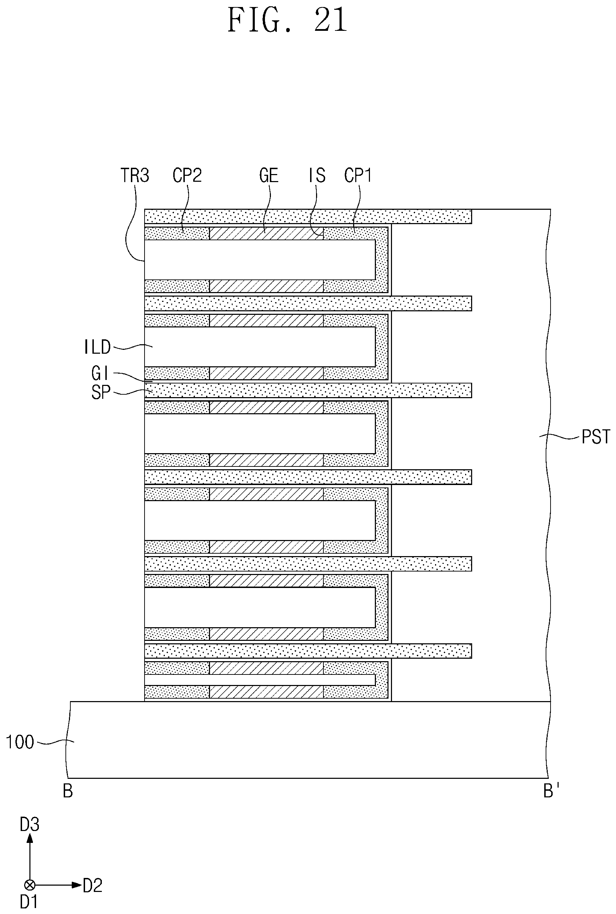

Referring back to FIGS. 3, 4A, and 4B, the device isolation pattern ST may be formed on the substrate 100. The bit line BL may be formed in the device isolation pattern ST. The preliminary device isolation pattern PST of FIG. 21 may be removed. The data storage pattern DSP may be formed on the second edge portion EA2 of the semiconductor patterns SP. Next, the upper insulating layer UIL may be formed to cover the substrate 100.

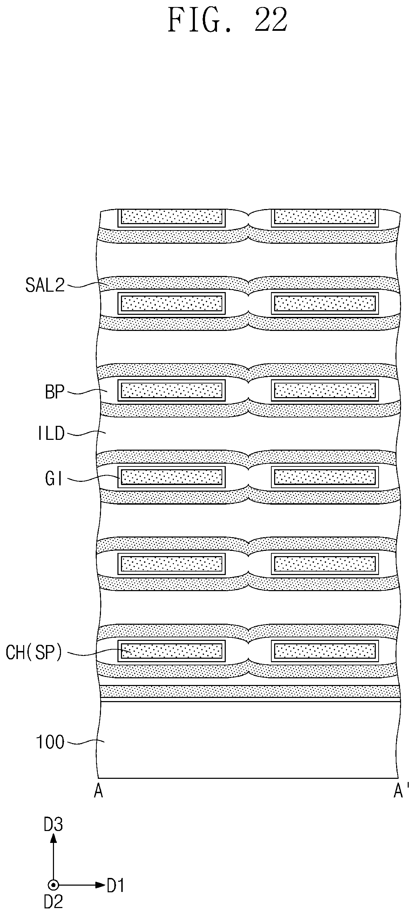

FIG. 22 is a diagram illustrating a method of fabricating a three-dimensional semiconductor device, according to an embodiment of the disclosure. In detail, FIG. 22 is a sectional view taken along the line A-A' of FIG. 16.

Referring to FIGS. 16 and 22, the bridge layer BPL of FIG. 15 may be removed less, compared with the process of removing the bridge layer BPL (of FIG. 15) described with reference to FIG. 17A. Thus, the bridge pattern BP may be formed to enclose the channel region CH of the semiconductor pattern SP and to extend in the first direction D1. Next, the afore-described fabrication process may be further performed to fabricate the three-dimensional semiconductor device described with reference to FIG. 5B.

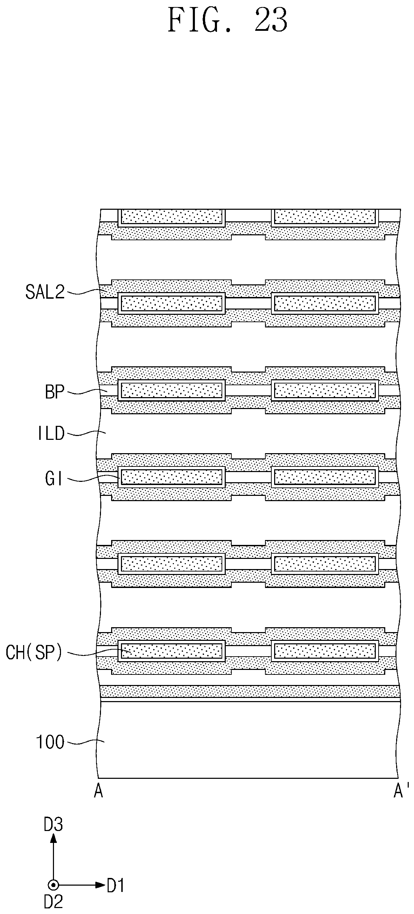

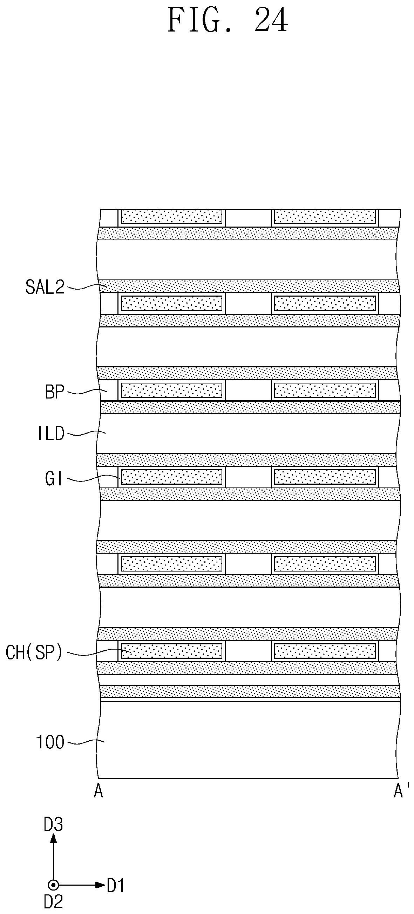

FIGS. 23 and 24 are diagrams illustrating a method of fabricating a three-dimensional semiconductor device, according to an embodiment of the disclosure. In detail, FIGS. 23 and 24 are sectional views taken along the line A-A' of FIG. 16.

Referring to FIGS. 16, 23, and 24, the bridge pattern BP may be formed by a method that is different from the method of forming the bridge pattern BP described with reference to FIGS. 15 and 17A.

In detail, a method of alternately and repeatedly performing the processes of forming and removing the preliminary bridge layer PBL of FIG. 15 may be used, instead of the method of performing the removal process after the process of forming the bridge layer BPL of FIG. 15. In this case, a stepwise portion may be formed between the gate insulating pattern GI and the bridge pattern BP, as shown in FIG. 23, and the bridge pattern BP may be formed to have substantially the same features as that described with reference to FIG. 5C. Similarly, the gate insulating pattern GI and the bridge pattern BP may be formed to have top surfaces that are coplanar with each other, as shown in FIG. 24, and the bridge pattern BP may be formed to have substantially the same features as that described with reference to FIG. 5D.

Next, the afore-described fabrication process may be further performed to fabricate the three-dimensional semiconductor device described with reference to FIG. 5C or 5D.

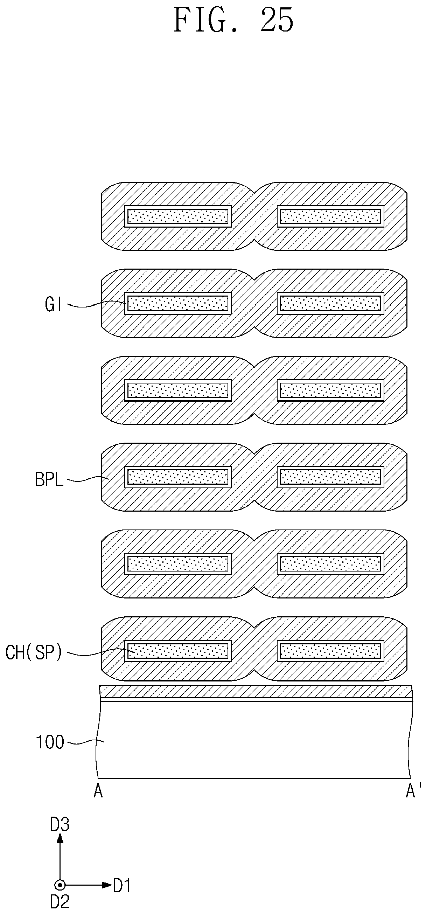

FIG. 25 is a diagram illustrating a method of fabricating a three-dimensional semiconductor device, according to an embodiment of the disclosure. In detail, FIG. 25 is a sectional view taken along the line A-A' of FIG. 13.

Referring to FIGS. 13 and 25, the bridge layer BPL including a conductive material may be formed to enclose the channel region CH of the semiconductor pattern SP and to extend in the first direction D1. In an embodiment, the bridge layer BPL may be formed of or include at least one from among TiN, TaN, WN, W, and Ti. Next, the afore-described fabrication process may be further performed to fabricate the three-dimensional semiconductor device described with reference to FIGS. 3 and 6.

According to an embodiment of the disclosure, a process of forming and removing a bridge layer may be performed before forming a sacrificial layer, and in this case, a bridge pattern may be formed to fill a space between semiconductor patterns. Thus, the sacrificial layer may be formed on each of top and bottom surfaces of the semiconductor patterns to extend in a specific direction, without filling the space between the semiconductor patterns. As a result, a void may not be formed in the gate pattern, when the gate pattern is formed in an empty region formed by removing the sacrificial layer through an intaglio process.

If the bridge pattern is not provided, the sacrificial layer may be formed to fill a space between the semiconductor patterns. Here, if the gate pattern is formed by replacing the sacrificial layer, the gate pattern may include a void between the semiconductor patterns. Due to the presence of the void, the gate pattern extending in a specific direction may be cut, and in this case, a process failure may occur. In addition, the electric characteristics of the gate pattern may be deteriorated due to the presence of the void.

Since the bridge pattern is provided, it may be possible to prevent the process failure and the deterioration of the electric characteristics. This may make it possible to improve the productivity and electric characteristics of the three-dimensional semiconductor device.

While non-limiting example embodiments of the disclosure have been particularly shown and described, it will be understood by one of ordinary skill in the art that variations in form and detail may be made therein without departing from the scope of the disclosure.

Embodiments are set out in the following clauses:
Clause 1. A three-dimensional semiconductor device, comprising:
   a substrate;
   semiconductor patterns that are on the substrate, spaced apart from the substrate, the semiconductor patterns spaced apart from each other in a first direction parallel to a top surface of the substrate;
   a first gate pattern on top surfaces of the semiconductor patterns and extending in the first direction;
   a second gate pattern on bottom surfaces of the semiconductor patterns, extending in the first direction, and spaced apart from the first gate pattern; and
   a bridge pattern between the semiconductor patterns,
   wherein each of the first gate pattern and the second gate pattern comprises:
      a gate region overlapped with the semiconductor patterns; and
      an extension region overlapped with the bridge pattern, and
   wherein a distance between the extension region of the first gate pattern and the extension region of the second gate pattern is smaller than a distance between the gate region of the first gate pattern and the gate region of the second gate pattern.
Clause 2. The three-dimensional semiconductor device of clause 1, wherein a lowermost surface of the extension region of the first gate pattern is located at a vertical level lower than a top surface of each of the semiconductor patterns, and
   wherein an uppermost surface of the extension region of the second gate pattern is located at a vertical level higher than a bottom surface of each of the semiconductor patterns.
Clause 3. The three-dimensional semiconductor device of clause 1 or clause 2, wherein a top surface of the extension region of the first gate pattern has an upwardly convex profile, and a bottom surface of the extension region of the first gate pattern has an upwardly concave profile, and
   wherein a top surface of the extension region of the second gate pattern has a downwardly concave profile, and a bottom surface of the extension region of the second gate pattern has a downwardly convex profile.
Clause 4. The three-dimensional semiconductor device of any of clauses 1 to 3, wherein a thickness of the bridge pattern in a second direction, perpendicular to the top surface of the substrate, decreases and then increases in the first direction.
Clause 5. The three-dimensional semiconductor device of any of clauses 1 to 4, wherein a top surface of the bridge pattern has an upwardly convex profile, and
   wherein a bottom surface of the bridge pattern has a downwardly convex profile.
Clause 6. The three-dimensional semiconductor device of any of clauses 1 to 5, wherein the bridge pattern comprises at least one from among SiO₂, SiON, SiOC, SiN, SiC, SiBN, C, CN, TiN, TaN, WN, W, and Ti.
Clause 7. A three-dimensional semiconductor device, comprising:
   a substrate;
   first semiconductor patterns on the substrate, spaced apart from the substrate, the first semiconductor patterns spaced apart from each other in a first direction parallel to a top surface of the substrate, and the first semiconductor patterns extending in a second direction that is parallel to the top surface of the substrate and crosses the first direction;
   second semiconductor patterns spaced apart from the first semiconductor patterns in a third direction perpendicular to the top surface of the substrate;
   a first gate pattern on top surfaces of the first semiconductor patterns and extending in the first direction;
   a second gate pattern on bottom surfaces of the first semiconductor patterns, extending in the first direction, and spaced apart from the first gate pattern;
   a bridge pattern between the first semiconductor patterns;
   a bit line on a first end of one of the first semiconductor patterns and extending in the third direction; and
   a data storage pattern on a second end of the one of the first semiconductor patterns, opposite of the first end, and extending in the third direction,
   wherein each of the first gate pattern and the second gate pattern comprises:
      a gate region overlapped with the first semiconductor patterns; and
      an extension region overlapped with the bridge pattern, and
   wherein the extension region of the first gate pattern protrudes to a region lower than the gate region of the first gate pattern.
Clause 8. A method of fabricating a three-dimensional semiconductor device, comprising:
   forming semiconductor patterns on a substrate, spaced apart from the substrate, wherein the semiconductor patterns are spaced apart from each other in a first direction parallel to a top surface of the substrate;
   forming a bridge layer that encloses each of the semiconductor patterns and extends in the first direction;
   performing a removal process on a portion of the bridge layer;
   forming a sacrificial layer on the semiconductor patterns, the sacrificial layer extending in the first direction;
   forming an interlayer insulating layer on the sacrificial layer;
   removing a portion of the sacrificial layer from a region between the interlayer insulating layer and the semiconductor patterns; and
   forming a gate pattern in an empty region, the empty region formed by the removing the portion of the sacrificial layer,
   wherein the removal process on the portion of the bridge layer reduces a thickness of the bridge layer.
Clause 9. The method of clause 8, wherein the bridge layer includes at least one from among SiO₂, SiON, SiOC, SiN, SiC, SiBN, C, CN, TiN, TaN, WN, W, and Ti.
Clause 10. The method of clause 8 or clause 9, wherein the sacrificial layer includes a material having an etch selectivity with respect to the bridge layer.
Clause 11. The method of any of clauses 8 to 10, wherein the sacrificial layer includes at least one from among SiN, SiO₂, SiC, SiOC, SiON, and SiBN.
Clause 12. The method of any of clauses 8 to 11, wherein the forming the gate pattern comprises:
   forming a first gate pattern in an empty region, which is formed by removing a portion of the sacrificial layer on top surfaces of the semiconductor patterns; and
   forming a second gate pattern in an empty region, which is formed by removing another portion of the sacrificial layer on bottom surfaces of the semiconductor patterns,
   wherein the first gate pattern and the second gate pattern are spaced apart from each other.
Clause 13. The method of any of clauses 8 to 12, wherein the removal process on the portion of the bridge layer divides the bridge layer into bridge patterns, the bridge patterns spaced apart from each other in the first direction.
Clause 14. The method of any of clauses 8 to 13, further comprising forming, before the forming the bridge layer, a gate insulating pattern that encloses each of the semiconductor patterns.
Clause 15. The method of any of clauses 8 to 14, wherein the forming the bridge layer comprising forming the bridge layer such that a portion of the bridge layer fills a space between the semiconductor patterns.
Clause 16. The method of clause 15, wherein the portion of the bridge layer filling the space between the semiconductor patterns is left after the removal process on the portion of the bridge layer is finished.
Clause 17. The method of any of clauses 8 to 16, wherein the forming the sacrificial layer is performed after the performing the removal process on the portion of the bridge layer.

## Claims

1. A three-dimensional semiconductor device, comprising:
a substrate;
semiconductor patterns that are on the substrate, spaced apart from the substrate, the semiconductor patterns spaced apart from each other in a first direction parallel to a top surface of the substrate;
a first gate pattern on top surfaces of the semiconductor patterns and extending in the first direction;
a second gate pattern on bottom surfaces of the semiconductor patterns, extending in the first direction, and spaced apart from the first gate pattern; and
a bridge pattern between the semiconductor patterns,
wherein each of the first gate pattern and the second gate pattern comprises:
a gate region that is overlapped with the semiconductor patterns; and
an extension region that is overlapped with the bridge pattern, and
wherein the extension region of the first gate pattern protrudes to a region below the gate region of the first gate pattern.

2. The three-dimensional semiconductor device of claim 1, wherein the extension region of the second gate pattern protrudes to a region higher than the gate region of the second gate pattern.

3. The three-dimensional semiconductor device of claim 1 or claim 2, wherein a distance between the extension region of the first gate pattern and the extension region of the second gate pattern is smaller than a distance between the gate region of the first gate pattern and the gate region of the second gate pattern.

4. The three-dimensional semiconductor device of any preceding claim, wherein a lowermost surface of the extension region of the first gate pattern is located at a vertical level lower than a top surface of each of the semiconductor patterns.

5. The three-dimensional semiconductor device of any preceding claim, wherein an uppermost surface of the extension region of the second gate pattern is located at a vertical level higher than a bottom surface of each of the semiconductor patterns.

6. The three-dimensional semiconductor device of any preceding claim, wherein a bottom surface of the extension region of the first gate pattern is located at a vertical level lower than a bottom surface of the gate region of the first gate pattern.

7. The three-dimensional semiconductor device of any preceding claim, wherein a top surface of the extension region of the first gate pattern has a downwardly concave profile.

8. The three-dimensional semiconductor device of any preceding claim, wherein each of top and bottom surfaces of the extension region of the second gate pattern has an upwardly convex profile.

9. The three-dimensional semiconductor device of any preceding claim, wherein a thickness of the bridge pattern in a third direction, perpendicular to the top surface of the substrate, decreases and then increases in the first direction.

10. The three-dimensional semiconductor device of any preceding claim, wherein a minimum thickness of the bridge pattern is smaller than a thickness of each of the semiconductor patterns.

11. The three-dimensional semiconductor device of any preceding claim, wherein a top surface of the bridge pattern has a downwardly concave profile, and
a bottom surface of the bridge pattern has an upwardly convex profile.

12. The three-dimensional semiconductor device of any preceding claim, wherein the bridge pattern comprises at least one from among SiO₂, SiON, SiOC, SiN, SiC, SiBN, C, CN, TiN, TaN, WN, W, and Ti.

13. The three-dimensional semiconductor device of any preceding claim, wherein the semiconductor patterns extend in a second direction that is parallel to the top surface of the substrate and crosses the first direction, and
wherein the three-dimensional semiconductor device further comprises:
a bit line on a first end of one of the semiconductor patterns and extending in a third direction perpendicular to the top surface of the substrate; and
a data storage pattern on a second end of the one of the semiconductor patterns, opposite of the first end, and extending in the third direction.
